# EUROPEAN PATENT SPECIFICATION

(11) **EP 1 785 459 B1**
(45) Date of publication and mention of the grant of the patent: **28.12.2016**
(21) Application number: 05780260.5
(22) Date of filing: 12.08.2005
(51) Int. Cl.: C09D 183/16, H01L 21/316, H01L 29/78, B32B 9/00, H01L 21/762, B32B 18/00, C01B 33/12, H01B 3/46, C08G 77/62, H01L 21/312, H01L 21/02, C08K 5/56

(54) **SILICEOUS FILM WITH SMALLER FLAT BAND SHIFT AND METHOD FOR PRODUCING SAME**
SILICIUMHALTIGER FILM MIT KLEINERER FLACHBANDVERSCHIEBUNG UND HERSTELLUNGSVERFAHREN DAFÜR
FILM SILICEUX COMPORTANT UN DECALAGE PLUS PETIT DE BANDE PLATE ET PROCEDE DE FABRICATION DE CELUI-CI

(30) Priority: 13.08.2004 JP 2004235792
(43) Date of publication of application: 16.05.2007
(73) Proprietor: Merck Patent GmbH, 64293 Darmstadt (DE)
(72) Inventor: SHIMIZU, Yasuo, Kakegawa-shi, Shizuoka 4371412 (JP); ICHIYAMA, Masaaki, Kakegawa-shi, Shizuoka 4371412 (JP); NAGURA, Teruno, Kakegawa-shi, Shizuoka 4371412 (JP)
(74) Representative: Isenbruck, Günter
(86) International application number: PCT/JP2005/014819
(87) International publication number: WO 2006/016672

(56) References cited:
- JP-A- 1 221 466
- JP-A- 6 299 118
- JP-A- 6 306 329
- JP-A- 7 196 986
- JP-A- 11 105 185
- JP-A- 11 105 187
- JP-A- 63 191 832
- JP-A- 2001 026 415
- JP-A- 2002 075 982

## Description

### TECHNICAL FIELD

The present invention provides a process for producing a siliceous film. More particularly, the present invention relates to a process for producing a siliceous film having a smaller flat band shift value and excellent insulating properties.

### BACKGROUND ART

In electronic devices such as semiconductor devices, semiconductor elements, for example, transistors, resistors and the like, are generally provided on a substrate. These elements should be electrically insulated from each other. Accordingly, a region for isolating the elements should be provided between these elements. This region is referred to as "isolation region." A siliceous film is generally used as a material for the formation of the isolation region.

Various processes for producing a siliceous film have been studied. Among them, a technique for producing a siliceous film by firing a thin film of polysilazane has been studied (for example, patent document 1 or 2).

The siliceous films produced by these processes are disadvantageous in that, due to the stay of nitrogen, carbon, and hydrogen considered attributable to a polysilazane as a starting material and a solvent, the flat band shift in a CV curve is higher than that in a siliceous film formed by high-density plasma CVD. Accordingly, the conventional siliceous films have room for improvement in insulating properties. In this case, particularly when the heating temperature should be low due to limitation on heat resistance and oxidation resistance of the substrate used, there is a tendency toward an increase in the amount of nitrogen, carbon, or hydrogen staying in the siliceous film.

On the other hand, techniques where an aluminum compound is added to a polysilazane compound, or aluminum is incorporated in the structure of a polysilazane compound, are also known (patent documents 3 and 4). In these patent documents, however, any study has not been made on the flat band shift of the siliceous film formed by the techniques.
- Patent document 1:: JP3511024B
- Patent document 2:: JP3178412B

- Patent document 3_{:}: JPH085963B

- Patent document 4:: JPH11105185

- Patent document 5:: JPH0463833

- Patent document 6:: JPH0931333

- Patent document 7:: JPH08176511

- Patent document 8:: JPH08176512

- Patent document 9:: JPH05345826

### DISCLOSURE OF INVENTION

### PROBLEMS TO BE SOLVED BY THE INVENTION

An object of the present invention is to solve the above problems of the prior art and to provide a process for producing a siliceous film having a smaller flat band shift value, that is, having excellent electrical characteristics such as insulating properties.

### MEANS FOR SOLVING THE PROBLEMS

According to the present invention, there is provided a coating composition consisting of:
at least one polysilazane compound selected from the group consisting of perhydropolysilazanes and modified perhydropolysilazanes, having a number average molecular weight of 100 to 50,000; an aluminum compound; and a solvent, said coating composition having an aluminum content of not less than 10 ppb and not more than 10 ppm in terms of the molar ratio of the aluminum atom to the silicon atom contained in the polysilazane compound.

Further, according to the present invention, there is provided a process for producing a siliceous film comprising coating a coating liquid onto a substrate and firing the coated substrate in an atmosphere containing steam, oxygen, or a mixed gas composed of steam and oxygen, said coating liquid consisting of:
at least one polysilazane compound selected from the group consisting of perhydropolysilazanes and modified perhydropolysilazanes, having a number average molecular weight of 100 to 50,000; an aluminum compound; and a solvent, said coating composition having an aluminum content of not less than 10 ppb and not more than 10 ppm in terms of the molar ratio of the aluminum atom to the silicon atom contained in the polysilazane compound.

Furthermore, according to the present invention, there is provided a siliceous film produced by coating a coating liquid consisting of a solvent, a polysilazane compound and an aluminum compound onto a substrate and firing the coated substrate under an oxidizing atmosphere, said siliceous film having an aluminum content of not less than 10 ppb and not more than 10 ppm in terms of the molar ratio of the aluminum atom to the silicon atom.

### EFFECT OF THE INVENTION

According to the present invention, a siliceous film having a smaller flat band shift value can be produced, whereby semiconductor elements having excellent electric characteristics, for example, element isolation films and gate insulation films having excellent insulating properties, can be formed.

### BEST MODE FOR CARRYING OUT THE INVENTION

Coating composition

In the coating composition according to the present invention, the at least one polysilazane compound selected from the group consisting of perhydropolysilazanes or modified perhydropolysilazanes may be any proper polysilazane compound according to need. In the present invention, the perhydropolysilazane is represented by general formula (I):

H-(SiH₂-NH)ₙ-H (I)

wherein n is a number indicating the degree of polymerization.

In the coating composition according to the present invention, a modified perhydropolysilazane prepared by modifying the perhydropolysilazane represented by general formula (I) with a silazane compound, an alcohol, or an amine may be used. In the present invention, the perhydropolysilazane is preferably used from the viewpoint of reducing the flat band shift of the siliceous film formed using the coating composition. This is because, when a polysilazane compound containing a relatively high organic group content as in the case where an organic group other than hydrogen is contained in the main chain, atoms such as the organic group-derived carbon remains in the siliceous film and, consequently, the effect of the present invention is lowered.

On the other hand, from the viewpoints of coatability in the formation of the film, storage stability and the like, in some cases, a modified perhydropolysilazane prepared by partially modifying a part of the perhydropolysilazane is preferably used. Compounds usable for the modification of the perhydropolysilazane include compounds such as hexamethyldisilazane, methyl alcohol, ethyl alcohol, and ethylenediamine. The modified perhydropolysilazane is provided by substituting a part of hydrogen atoms, particularly terminal hydrogen, in the perhydropolysilazane using these compound. Such modified perhydropolysilazanes are described in patent documents 5 to 9.

The weight average molecular weight of the perhydropolysilazane or the modified perhydropolysilazane used in the coating composition according to the present invention is 100 to 50,000, preferably 500 to 20,000, from the viewpoint of the coatability in coating particularly by spin coating.

In the coating composition according to the present invention, the polysilazane compound is dissolved in a solvent. The solvent used in this case is preferably an active hydrogen-free inert organic solvent. Solvents usable herein include aromatic hydrocarbon solvents such as benzene, toluene, xylene, ethylbenzene, diethylbenzene, trimethylbenzene, and triethylbenzene; alicyclic hydrocarbon solvents such as cyclohexane, cyclohexene, decahydronaphthalene, ethylcyclohexane, methylcyclohexane, p-menthane, dipentene (limonene), and pinene; saturated, hydrocarbon compounds such as n-pentane, i-pentane, n-hexane, i-hexane, n-heptane, i-heptane, n-octane, i-octane, n-nonane, i-nonane, n-decane, and i-decane; ether solvents such as dipropyl ether and dibutyl ether; ketone solvents such as methyl isobutyl ketone; and ester solvents such as propylene glycol monomethyl ether acetate. Among them, solvents capable of satisfactorily dissolving aluminum compounds which will be described later are particularly preferred.

The aluminum compound used in the present invention is not particularly limited. However, aluminum compounds dissolved in the polysilazane solution are preferred. Accordingly, the aluminum compound can be properly selected depending upon the solvent used in the coating composition.

The aluminum compound usable in the present invention can be represented, for example, by the following general formula:

Al(Z¹)(Z²)(Z³) (A)

wherein Z¹, Z² and Z³ each independently represent a group selected from the group consisting of hydrogen, a hydroxyl group, a halogen atom, an alkyl group, a cycloalkyl group, an aryl group, an alkenyl group, a cycloalkenyl group, an alkoxy group, and an acetyl acetonate group, provided that two or three of Z¹, Z² and Z³ may form a cyclic structure and Z¹, Z² and Z³ may represent a silicon-containing organic group.

In the present invention, among these aluminum compounds, those represented by general formulae (A-1) to (A-3) are preferred:

AI(OR¹)(OR²)(OR³) (A-1)

Al(R¹)(R²)(R³) (A-2)

Al(X¹)(X²)(X³) (A-3)

wherein R¹, R² and R³ each independently represent hydrogen, an alkyl group having 1 to 20 carbon atoms, a cycloalkyl group, or an aryl group; and X¹, X² and X³ each independently represent fluorine, chlorine, or iodine.

More specifically, aluminum compounds usable in the present invention include trimethoxyaluminum, triethoxyaluminum, triisopropoxyaluminum, tri-n-propoxyaluminum, trimethylaluminum, triethylaluminum, triisopropylaluminum, tri-n-propylaluminum, aluminum fluoride, aluminum chloride, aluminum iodide, aluminum triacetylacetonate, and aluminum triethylacetoacetate. Further, silicon-containing aluminum compounds, for example, di-s-butoxyaluminoxy-triethoxysilane, may also be used.

The molar ratio of the aluminum atom to the silicon atom contained in the polysilazane compound is not less than 10 ppb, more preferably not less than 100 ppb. Further, from the viewpoint of maintaining good withstanding voltage properties, the molar ratio of the aluminum atom to the silicon atom contained in the polysilazane compound is not more than 10 ppm. The above addition amount of the aluminum compound is much smaller than that described in patent document 3 or 4. It is surprising that the properties of the formed siliceous film can be dramatically improved by using the very small amount of the aluminum compound.

In the coating composition according to the present invention, the aluminum compound may be added to the coating composition by any desired method. Specifically, the aluminum compound may be added, for example, by a method in which a solid aluminum compound is added to and dissolved in the coating composition, or a method in which an aluminum compound is dissolved in a solvent to prepare a solution which is then mixed into the coating composition. When the aluminum compound is dissolved in the solvent, the solvent may be one usable in the dissolution of the polysilazane compound. In this case, the solvent used in the dissolution of the polysilazane compound may be different from the solvent used in the preparation of the aluminum compound solution. The temperature and pressure at which the aluminum compound is added is not particularly limited. In general, however, the aluminum compound is generally added at 0 to 200°C and at the atmospheric pressure to 10 kg/cm²G.

### Production process of siliceous film

The production process of a siliceous film according to the present invention comprises coating the above coating composition onto a substrate and firing the coated substrate to form a siliceous film.

The surface material of the substrate used is not particularly limited, and examples thereof include bare silicon, and silicon wafers with a thermally grown oxide film or a silicon nitride film optionally formed thereon. If necessary, a structure such as a trench isolation groove may be formed on the substrate.

Methods usable for coating the coating composition onto the surface of the substrate include conventional methods, for example, spin coating, dip coating, spray coating, and transfer methods.

If necessary, excess organic solvent is removed (by drying) from the coating film formed on the surface of the substrate. The coating film is then fired in an atmosphere containing steam, oxygen or a mixed gas composed of steam and oxygen, that is, in an oxidizing atmosphere. In this case, an inert gas such as nitrogen or helium may be present as a mixture in such an amount range that is not detrimental to the effect of the present invention.

In the process according to the present invention, preferably, the firing is carried out under relatively strong oxidizing conditions from the viewpoint of minimizing impurity elements, for example, carbon, hydrogen, and nitrogen, remaining in the siliceous film. In the present invention, firing under an oxygen-containing atmosphere is particularly preferred. The oxygen content is preferably not less than 1%, more preferably not less than 10% by volume.

Further, in the process according to the present invention, when the firing is carried out in a steam-containing atmosphere, the steam content is preferably not less than 0.1% by volume, more preferably not less than 1% by volume. In the present invention, preferably, firing under a mixed gas atmosphere containing oxygen and steam is particularly preferred.

The firing temperature should be such that the polysilazane compound can be added to the siliceous film. The firing temperature is generally 100 to 1,200°C, preferably 300 to 1,000°C. There is a tendency that, as compared with the conventional production process, the effect of improving the flat band shift becomes more significant with decreasing the firing temperature. Further, there is a tendency that a siliceous film having a smaller flat band shift and better electric properties is provided as the firing temperature increases.

The firing time may be properly selected depending upon the firing temperature but is generally 5 min to 10 hr. The firing time is preferably one hr or shorter from the viewpoint of the efficiency of the production.

The siliceous film produced by the production process according to the present invention has a smaller flat band shift value. It is considered that this property is derived from the homogeneous dispersion of the aluminum compound-derived aluminum oxide in the formed siliceous film. By virtue of this property, the siliceous film according to the present invention has excellent electrical characteristics, for example, excellent insulating properties.

### Siliceous film, and substrate with siliceous film

The siliceous film and substrate with a siliceous film according to the present invention may be produced, for example, by the above production process. In general, in the production of the siliceous film, the ratio between the aluminum atom in the aluminum compound as the starting material and the silicon atom in the polysilazane compound as the starting material remains unchanged in the finally obtained siliceous film. Accordingly, the siliceous film according to the present invention can be produced by using the aluminum compound in the formation of the siliceous film so that the ratio of the aluminum atom to the silicon atom is not less than 10 ppb and not more than 10 ppm. Alternatively, in the above method, for example, a siliceous film having a low aluminum content is first formed followed by introduction of an aluminum atom into the film, by another means, for example, ion implantation, to bring the final aluminum content to not less than 10 ppb and not more than 10 ppm.

The siliceous film and substrate with a siliceous film have excellent electrical characteristics and thus are useful for use in various semiconductor elements, for example, element isolation films, interlayer insulating films such as premetal dielectric films and intermetallic dielectric films, and gate insulating films for liquid crystal display devices and the like.

### Reference Synthesis Example 1 Synthesis of perhydropolysilazane

A reactor comprising a four-necked flask having an internal volume of 2 liters and equipped with a gas blow pipe, a mechanical stirrer, and a Dewar condenser was provided. The air in the reactor was replaced by dry nitrogen, and 1500 ml of dry pyridine was introduced into the four-necked flask, followed by ice cooling. Next, 100 g of dichlorosilane was added to pyridine in the flask. This resulted in the production of an adduct (SiH₂Cl₂·2C₅H₅N) as a white solid. This reaction mixture was further ice-cooled, and 70 g of ammonia was blown into the reaction mixture with stirring. Subsequently, dry nitrogen was blown into the reaction mixture for 30 min to remove excess ammonia.

The reaction mixture was then filtered in a dry nitrogen atmosphere through a Buchner funnel under reduced pressure to give 1200 ml of a filtrate. Pyridine was removed from this filtrate by an evaporator to give 40 g of perhydropolysilazane.

The molecular weight of the perhydropolysilazane was measured by gel permeation chromatography using CDCl₃ as a developing solution and was found to be 800 in terms of number average molecular weight as determined using polystyrene as a standard. Further, an infrared absorption spectrum of the perhydropolysilazane was measured. As a result, absorption attributable to N-H bond was observed at wavenumbers (cm⁻¹) 3350 and 1180; absorption attributable to Si-H bond was observed at wavenumber (cm⁻¹) 2170; and absorption attributable to Si-N-Si bond was observed at wavenumber (cm⁻¹) 1020 to 820.

### Comparative Example 1

The perhydropolysilazane (20 g) prepared in Reference Synthesis Example 1 was dissolved in 80 g of dibutyl ether, which had been dehydrated with a molecular sieve, and the solution was filtered through a PTFE syringe filter with a filtration accuracy of 0.1 µm manufactured by ADVANTEC.

A substrate comprising a 10 nm-thick thermally grown oxide film formed on a p-type silicon wafer having a diameter of 8 inches was provided. The polysilazane solution was spin coated on the oxide film at a main spin speed of 1000 rpm/20 sec. After coating, the substrate was dried by heating on a hot plate at 150°C for 3 min. Subsequently, the substrate was heated to form a 500 nm-thick siliceous film. Heating conditions were as follows.

Heating condition 1: Heated at 400°C for 15 min under an atmosphere with steam concentration 80% by volume and oxygen concentration 20% by volume.

Heating condition 2: Heated at 800°C for 15 min under an atmosphere with steam concentration 80% by volume and oxygen concentration 20% by volume.

Heating condition 3: Heated at 400°C for 15 min under an atmosphere with steam concentration 80% by volume and oxygen concentration 20% by volume, followed by heating at 800°C for 30 min in a dry nitrogen atmosphere.

Heating condition 4: Heated at 400°C for 30 min in a nitrogen atmosphere.

For each of the substrates thus obtained, flat band shift was measured. At the outset, each of the substrates was confirmed to have a film thickness of 500 nm by thickness measurement with an ellipsometer (Model-M44, manufactured by J.A. Woolam). Further, a CV curve and a flat band shift value based on the curve were measured with an automatic mercury probe CV/IV measuring device (Model SSM 495, manufactured by SSM Japan). The voltage applied in the CV measurement was in the range of -100 to +100 V.

### Comparative Example 2

For a high-density plasma CVD film, the flat band value was measured in the same manner as in Comparative Example 1.

### Example 1

Tri(isopropoxy)aluminum (1 g) was mixed into 100 g of dehydrated dibutyl ether to give a tri(isopropoxy)aluminum solution.

The perhydropolysilazane (20 g) prepared in Reference Synthesis Example 1 was dissolved in 80 g of dibutyl ether, which had been dehydrated with a molecular sieve. The aluminum compound solution (27 mg) containing tri(isopropoxy)aluminum was added to this solution, and the mixed solution was filtered through a PTFE syringe filter with a filtration accuracy of 0.1 µm manufactured by ADVANTEC.

The flat band value was measured in the same manner as in Comparative Example 1, except that this mixed solution was used.

### Example 2

The flat band value was measured in the same manner as in Example 1, except that tri(acetyl acetonate)aluminum was used instead of tri(isopropoxy)aluminum and the amount of the aluminum compound solution added was changed to 43 mg.

### Example 3

The flat band value was measured in the same manner as in Example 1, except that (ethyl acetoacetate)di(isopropoxy)aluminum was used instead of tri(isopropoxy)aluminum and the amount of the aluminum compound solution added was changed to 34 mg.

### Example 4

The flat band value was measured in the same manner as in Example 1, except that tri(ethyl acetoacetate)aluminum was used instead of tri(isopropoxy)aluminum and the amount of the aluminum compound solution added was changed to 56 mg.

### Example 5

The flat band value was measured in the same manner as in Example 1, except that aluminum chloride was used instead of tri(isopropoxy)aluminum and the amount of the aluminum compound solution added was changed to 18 mg.

### Example 6

The flat band value was measured in the same manner as in Example 1, except that di-s-butoxyaluminoxy-triethoxysilane was used instead of tri(isopropoxy)aluminum and the amount of the aluminum compound solution added was changed to 47 mg.

### Comparative Example 3

The flat band value was measured in the same manner as in Example 1, except that the amount of tri(isopropoxy)aluminum to be dissolved in dibutyl ether was changed to 0.001 g.

### Comparative Example 4

The flat band value was measured in the same manner as in Example 1, except that the amount of the tri(isopropoxy)aluminum solution to be added to the polysilazane solution was changed to 2.7 g.

### Example 7

Methyl alcohol (10 g) was mixed and thoroughly dissolved into 90 g of dehydrated dibutyl ether. This solution (10 g) was sampled, and 100 g of the perhydropolysilazane solution prepared in Comparative Example 1 was gradually added thereto with stirring. This mixed solution was heated at 80°C for one hr in a nitrogen atmosphere and was allowed to cool. This reaction resulted in the formation of an ethyl alcohol-modified perhydropolysilazane solution.

The flat band value was measured in the same manner as in Example 1, except that this modified perhydropolysilazane solution was used.

### Results of evaluation

The results obtained for Comparative Examples 1 and 2 and Examples 1 to 6 were as follows.

**[Table 1]**

| | Al con-tent* | Heating condition 1 | Heating condition 2 | Heating condition 3 | Heating condition 4 (comparative) |
|---|---|---|---|---|---|
| Comparative Example 1 | 0 | -18.5 | -13.0 | -22.0 | -45.2 |
| Comparative Example 2 | 0 | -7.0 to -15.0 | | | |
| Example 1 | 3 ppm | -11.2 | -8.5 | -9.5 | -38.2 |
| Example 2 | 3 ppm | -10.0 | -6.2 | -11.0 | -44.0 |
| Example 3 | 3 ppm | -9.3 | -9.0 | -10.1 | -40.5 |
| Example 4 | 3 ppm | -11.0 | -7.8 | -10.2 | -46.2 |
| Example 5 | 3 ppm | -9.9 | -7.2 | -8.9 | -39.5 |
| Example 6 | 3 ppm | -10.4 | -8.8 | -10.4 | -50.2 |
| Comparative Example 3 | 3 ppb | -19:0 | -13.4 | -22.4 | |
| Comparative Example 4 | 300 ppm | Immeasurable | Immeasurable | Immeasurable | |
| Example 7 | 3 ppm | -11.4 | -6.2 | -8.0 | |
| Unit: V | | | | | |

| | | | | | |
|---|---|---|---|---|---|
| Al content: Proportion of the number of aluminum atoms to the number of silicon atoms | | | | | |

In Examples 1 and 4, the content of aluminum in siliceous films produced under respective firing conditions was measured with a secondary ion mass spectrometer (Model 6650, manufactured by Physical Electronics) and a tracer-type surface shape measuring device (Model DEKTAK8000, manufactured by SLDAN). As a result, the aluminum content was substantially identical to the aluminum content of the coating liquid, indicating that the content of aluminum in the coating composition is identical to the content of aluminum in the siliceous film produced using the coating composition. Further, it was found that the aluminum content was constant in the thickness-wise direction of the siliceous film, and the aluminum atom was evenly distributed in the siliceous film.

### INDUSTRIAL APPLICABILITY

This invention can provide a production process of a siliceous film having a smaller flat band shift value, that is, a siliceous film having excellent insulating properties. The siliceous film produced by this process is utilizable, for example, in semiconductor elements, for example, element isolation films, interlayer insulating films such as premetal dielectric films and intermetallic dielectric films, and gate insulating films for liquid crystal display devices and the like.

## Claims

1. A coating composition consisting of: at least one polysilazane compound selected from the group consisting of perhydropolysilazanes and modified perhydropolysilazanes, having a number average molecular weight of 100 to 50,000; an aluminum compound; and a solvent, said coating composition having an aluminum content of not less than 10 ppb and not more than 10 ppm in terms of the molar ratio of the aluminum atom to the silicon atom contained in the polysilazane compound.

2. The coating composition according to claim 1, wherein said modified perhydropolysilazane is a modification product of a perhydropolysilazane with a silazane compound, an alcohol, or an amine.

3. The coating composition according to claim 1 or 2, wherein said aluminum compound is represented by general formula (A):
Al(Z¹)(Z²)(Z³) (A)
wherein Z¹, Z² and Z³ each independently represent a group selected from the group consisting of hydrogen, a hydroxyl group, a halogen atom, an alkyl group, a cycloalkyl group, an aryl group, an alkenyl group, a cycloalkenyl group, an alkoxy group, and an acetyl acetonate group, provided that two or three of Z¹, Z² and Z³ may form a cyclic structure and Z¹, Z² and Z³ may represent a silicon-containing organic group.

4. The coating composition according to any one of claims 1 to 3, wherein said coating composition has an aluminum content of not less than 100 ppb and not more than 10 ppm in terms of the molar ratio of the aluminum atom to the silicon atom contained in the polysilazane compound.

5. A process for producing a siliceous film comprising coating a coating composition onto a substrate and firing the coated substrate in an atmosphere containing steam, oxygen, or a mixed gas composed of steam and oxygen, said coating composition consisting of: at least one polysilazane compound selected from the group consisting of perhydropolysilazanes and modified perhydropolysilazanes, having a number average molecular weight of 100 to 50,000; an aluminum compound; and a solvent, said coating composition having an aluminum content of not less than 10 ppb and not more than 10 ppm in terms of the molar ratio of the aluminum atom to the silicon atom contained in the polysilazane compound.

6. The process for producing a siliceous film according to claim 5, wherein said firing is carried out under an atmosphere containing oxygen or a mixed gas composed of oxygen and steam.

7. A siliceous film, produced by the process according to claim 5 or 6.

8. A substrate with a siliceous film, comprising a substrate and a siliceous film, produced by a process according to claim 5 or 6, provided on at least one surface of said substrate.

9. The substrate with a siliceous film according to claim 8, wherein said siliceous film is an element isolation film, an interlayer insulating film, or a gate insulating film.

## Patentansprüche

1. Eine Beschichtungszusammensetzung bestehend aus: mindestens einer Polysilazanverbindung ausgewählt aus der Gruppe bestehend aus Perhydropolysilazanen und modifizierten Perhydropolysilazanen, aufweisend ein zahlengemitteltes Molekulargewicht von 100 bis 50.000; eine Aluminiumverbindung und ein Lösungsmittel, wobei die Beschichtungszusammensetzung einen Aluminiumgehalt von nicht weniger als 10 ppb und nicht mehr als 10 ppm, was das Molverhältnis des Aluminiumatoms zu dem Siliciumatom enthalten in der Polysilazanverbindung betrifft, aufweist.

2. Die Beschichtungszusammensetzung nach Anspruch 1, wobei das modifizierte Perhydropolysilazan ein Umwandlungsprodukt aus einem Perhydropolysilazan mit einer Silazanverbindung, einem Alkohol oder einem Amin ist.

3. Die Beschichtungszusammensetzung nach Anspruch 1 oder 2, wobei die Aluminiumverbindung durch die allgemeine Formel (A) dargestellt ist:
Al(Z¹)(Z²)(Z³) (A)
wobei Z¹, Z² und Z³ jeweils unabhängig eine Gruppe darstellen ausgewählt aus der Gruppe bestehend aus Wasserstoff, einer Hydroxylgruppe, einem Halogenatom, einer Alkylgruppe, einer Cycloalkylgruppe, einer Arylgruppe, einer Alkenylgruppe, einer Cycloalkenylgruppe, einer Alkoxygruppe und einer Acetylacetonatgruppe, mit der Maßgabe, dass zwei oder drei Z¹, Z² und Z³ eine Ringstruktur bilden können und Z¹, Z² und Z³ eine Silicium enthaltende organische Gruppe darstellen können.

4. Die Beschichtungszusammensetzung nach einem der Ansprüche 1 bis 3, wobei die Beschichtungszusammensetzung einen Aluminiumgehalt von nicht weniger als 100 ppb und nicht mehr als 10 ppm aufweist, was das Molverhältnis des Aluminiumatoms zu dem Siliciumatom enthalten in der Polysilazanverbindung betrifft.

5. Ein Verfahren zur Herstellung eines siliciumhaltigen Films umfassend Auftragen einer Beschichtungszusammensetzung auf ein Substrat und Brennen des beschichteten Substrats in einer Atmosphäre enthaltend Dampf, Sauerstoff oder ein Mischgas zusammengesetzt aus Dampf und Sauerstoff, die Beschichtungszusammensetzung bestehend aus: mindestens einer Polysilazanverbindung ausgewählt aus der Gruppe bestehend aus Perhydropolysilazanen und modifizierten Perhydropolysilazanen, aufweisend ein zahlengemitteltes Molekulargewicht von 100 bis 50.000; eine Aluminiumverbindung und ein Lösungsmittel, wobei die Beschichtungszusammensetzung einen Aluminiumgehalt von nicht weniger als 10 ppb und nicht mehr als 10 ppm, was das Molverhältnis des Aluminiumatoms zum Siliciumatom enthalten in der Polysilazanverbindung betrifft, aufweist.

6. Verfahren zur Herstellung eines siliciumhaltigen Films nach Anspruch 5, wobei das Brennen unter einer Atmosphäre, enthaltend Sauerstoff oder ein Mischgas zusammengesetzt aus Sauerstoff und Dampf, ausgeführt wird.

7. Ein siliciumhaltiger Film, hergestellt nach dem Verfahren nach Anspruch 5 oder 6.

8. Ein Substrat mit einem siliciumhaltigen Film, umfassend ein Substrat und einen siliciumhaltigen Film, hergestellt nach einem Verfahren nach Anspruch 5 oder 6, bereitgestellt auf mindestens einer Oberfläche des Substrates.

9. Das Substrat mit einem siliciumhaltigen Film nach Anspruch 8, wobei der siliciumhaltige Film ein Element-Isolationsfilm, ein Zwischenlagen-Isolationsfilm oder ein Gate-Isolationsfilm ist.

## Revendications

1. Composition de revêtement se composant : d'au moins un composé de polysilazane sélectionné dans le groupe constitué par des perhydropolysilazanes et des perhydropolysilazanes modifiés, présentant un poids moléculaire moyen en nombre allant de 100 à 50 000 ; d'un composé d'aluminium ; et d'un solvant, ladite composition de revêtement présentant une teneur en aluminium supérieure ou égale à 10 ppb et inférieure ou égale à 10 ppm en termes du rapport molaire de l'atome d'aluminium sur l'atome de silicium contenu dans le composé de polysilazane.

2. Composition de revêtement selon la revendication 1, dans laquelle ledit perhydropolysilazane modifié est un produit de modification d'un perhydropolysilazane avec un composé de silazane, un alcool ou une amine.

3. Composition de revêtement selon la revendication 1 ou 2, dans laquelle ledit composé d'aluminium est représenté par la formule générale (A) :
Al(Z¹) (Z²) (Z³) (A)
dans laquelle Z¹, Z² et Z³ représentent chacun de façon indépendante un groupe sélectionné dans le groupe constitué par l'hydrogène, un groupe hydroxyle, un atome d'halogène, un groupe alkyle, un groupe cycloalkyle, un groupe aryle, un groupe alcényle, un groupe cycloalcényle, un groupe alkoxy et un groupe acétylacétonate, à condition que deux ou trois des Z¹, Z² et Z³ puissent former une structure cyclique et que Z¹, 2² et Z³ puissent représenter un groupe organique contenant du silicium.

4. Composition de revêtement selon l'une quelconque des revendications 1 à 3, dans laquelle ladite composition de revêtement présente une teneur en aluminium supérieure ou égale à 100 ppb et inférieure ou égale à 10 ppm en termes du rapport molaire de l'atome d'aluminium sur l'atome de silicium contenu dans le composé de polysilazane.

5. Procédé pour produire un film siliceux consistant à recouvrir une composition de revêtement sur un substrat et à cuire le substrat revêtu dans une atmosphère contenant de la vapeur, de l'oxygène ou un gaz mixte composé de vapeur et d'oxygène, ladite composition de revêtement se composant d'au moins un composé de polysilazane sélectionné dans le groupe constitué par des perhydropolysilazanes et des perhydropolysilazanes modifiés, présentant un poids moléculaire moyen en nombre allant de 100 à 50 000 ; d'un composé d'aluminium ; et d'un solvant, ladite composition de revêtement présentant une teneur en aluminium supérieure ou égale à 10 ppb et inférieure ou égale à 10 ppm en termes du rapport molaire de l'atome d'aluminium sur l'atome de silicium contenu dans le composé de polysilazane.

6. Procédé pour produire un film siliceux selon la revendication 5, dans lequel ladite cuisson est effectuée dans une atmosphère contenant de l'oxygène ou un gaz mixte composé d'oxygène et de vapeur.

7. Film siliceux produit par le procédé selon la revendication 5 ou 6.

8. Substrat ayant un film siliceux, comprenant un substrat et un film siliceux, produit par un procédé selon la revendication 5 ou 6, disposé sur au moins une surface dudit substrat.

9. Substrat ayant un film siliceux selon la revendication 8, dans lequel ledit film siliceux est un film d'isolation d'élément, un film d'isolation d'intercouche ou un film d'isolation de grille.
